# EUROPEAN PATENT SPECIFICATION

(11) **EP 1 686 197 B1**
(45) Date of publication and mention of the grant of the patent: **13.04.2016**
(21) Application number: 04818871.8
(22) Date of filing: 12.11.2004
(51) Int. Cl.: C23C 14/56, C23C 14/14, C23C 14/02, G11B 5/85

(54) **TAKE-UP VACUUM DEPOSITION METHOD AND TAKE-UP VACUUM DEPOSITION APPARATUS**
AUFNAHME-VAKUUMABSCHEIDUNGSVERFAHREN UND AUFNAHME-VAKUUMABSCHEIDUNGSVORRICHTUNG
PROCEDE DE DEPOT SOUS VIDE PAR ENROULEMENT ET APPAREIL DE DEPOT SOUS VIDE PAR ENROULEMENT

(30) Priority: 20.11.2003 JP 2003390105
(43) Date of publication of application: 02.08.2006
(73) Proprietor: ULVAC, INC., Chigasaki-shi, Kanagawa 253-8543 (JP)
(72) Inventor: HAYASHI, Nobuhiro;, Kanagawa;2538543 (JP); HIRONO, Takayoshi;, Kanagawa;2538543 (JP); TADA, Isao;, Kanagawa;2538543 (JP); NAKATSUKA, Atsushi;, Kanagawa;2538543 (JP)
(74) Representative: D Young & Co LLP
(86) International application number: PCT/JP2004/016839
(87) International publication number: WO 2005/049883

(56) References cited:
- EP-A- 0 387 904
- EP-A- 0 756 020
- JP-A- 2 175 871
- JP-A- 10 081 958
- JP-A- 58 064 381
- JP-A- 61 030 669
- JP-A- 2002 358 633

## Description

### [Technical Field]

This invention relates to a vacuum evaporation deposition method of the winding type in which an insulting film is continuously dispensed in reduced pressure atmosphere, and cooled by a cooling roller in close contact, and a metal film is deposited on the insulating film and the metal-deposited film is wound up on a take-up roller.

### [Background of the Technique]

In the prior art, such an evaporation deposition method of the winding type in which a long material film is continuously dispensed from a dispense roller, passing along a cooling can roller in contact and evaporation material from an evaporation source facing to the can roller is deposited on the material film, and the deposited material film is wound up on a take-up roller. That is disclosed, for example, in the following patent literature 1.

In the vacuum evaporation deposition method of such a kind, a material film is cooled in contact with the peripheral surface of a cooling can roller to prevent thermal deformation, and a film is formed on the cooled material film. Accordingly, it is an important problem how the material film is closely contacted with the cooling can roller, in the vacuum evaporation deposition method.

An arrangement to obtain a close contact between the material film and the cooling can roller is disclosed, for example, in the following patent literature 2. Fig.5 shows a schematic construction of a film-forming apparatus of the winding type, described in the patent literature 2, in which the film is deposited by the plasma CVD method.

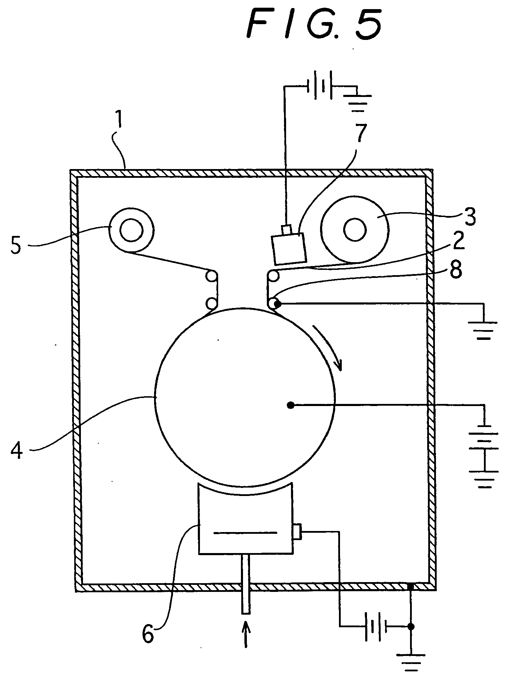

Referred to Fig5, a dispense roller 3 with a wound film 2 on which a metal film is formed, a cooling can roller 4 and a take-up roller 5 are arranged in a vacuum chamber under the reduced pressure. A reaction gas supply source 6 is arranged under the cooling can roller 4. A primary conductive thin film is formed on an insulating film, in the film 2 with metal film. A reaction gas from a reaction gas supply source 6 reacts on the primary conductive thin film to make film formed. An insulating layer is formed on the surface of the can roller 4 made of metal. A predetermined negative potential is applied onto the roll body.

And an electron beam radiator 7 is arranged between the dispensing roller 3 and the can roller 4, in the film-forming apparatus (plasma CVD) of the winding type as shown in Fig. 5. A guide roller 8 is arranged between the electron beam radiator 7 and the can roller 4 to connect the conductive film of the film 2 to the earth. Thus, the film 2 with metal film is charged with the electron beam onto the insulating layer surface thereof. The film 2 is closely contacted with the can roller 4, by the electrical attractive force between the can roller 4 and the film 2 with metal film.

Patent Document 1: JP7-118835A
Patent Document 2: JP2000-17440A
EP 0387904A relates to a method of producing a thin film.

### [Disclosure of Invention]

### [Problem to be solved by the Invention]

However, only plastic film with conductive film such as the film 2 with metal film is applicable in the prior art film-forming apparatus (plasma CVD) as shown in Fig.5. There is a problem that the prior art apparatus is not suitable for metal film deposition on a material film such as plastics.

In the prior art film-forming apparatus (CVD) of the winding type, bias potential applied to the cooling can roller can be effective to the film with metal film which is already formed thereon. However, when a metal film is newly deposited, the bias potential cannot be applied to the material film before the metal film deposition. When only a material film is charged before the metal film is deposited, electric charges are diffused onto the deposited metal film during the metal deposition. On that cause, electro-static attractive force is lowered between the can roller and the material film and so the contact force is deteriorated.

Accordingly, the charge method and the bias application method employed in the prior art deposition apparatus of the winding type are not suitable for the metal film deposition on the material film such as plastic film, and a high contact force cannot be obtained between the cooling can roller and the metal film. The material film is shrunk and deformed due to the deficiency of the cooling effect of the material film. The running speed of the material film cannot be risen up. Accordingly, the productivity cannot be improved.

This invention has been made in consideration of the above problems. It is an object of this invention to provide a vacuum evaporation deposition method of the winding type and a vacuum evaporation deposition apparatus of the winding type in which a thermal deformation of a material film such as plastics is suppressed and a metal film can be formed at a high speed, and superior in productivity.

### [Means for Solving Problem]

The above-described object can be achieved by a vacuum evaporation deposition method of the winding type according to claim 1.

Further, the object of this invention is achieved by a vacuum evaporation deposition apparatus of the winding type according to claim 6.

Before deposition of metal film, said material film electrified with irradiation of the charged particles is made to be close contacted to the cooling roller, to which a bias potential is applied, by electro-static attractive force. On the other hand, after deposition of the metal film, a part of charges on the film is dissipated with metal film deposited. However, a potential is applied to the metal film in contact with said auxiliary roller. Thus, electro-static attraction occurs between said metal film and said cooling roller. Accordingly, also after the deposition of metal, attraction force is maintained between said film and said cooling roller.

Thus, in this invention, highly close contact force can be obtained between said film and cooling roller both before and after of deposition of metal, and so the cooling efficiency of said film can be maintained. Thermal deformation of said film can be prevented on the deposition of metal and the running speed of said film can be raised. And productivity can be improved.

On the other hand, when a bias potential becomes higher than a predetermined value between the cooling roller and the auxiliary roller or the metal film on the material film, there occurs the fear that evaporation metal splashes to cause short-circuit and thermal damage and so the quality is deteriorated. Preferably, surface potential of the deposited metal film is measured and a step to control the applied voltage is provided to be put within a predetermined range. Thus, the damage due to splash of depositing metal can be avoided. And so the stabilization of quality can be obtained. Said predetermined range is within a range between lower voltage to obtain a suitable close contact force between said material film and said cooling roller and upper voltage to avoid the damage due to splash of depositing method. It can be selected in accordance with the material of film, thickness and film-running speed.

### [Effect of the Invention]

According to this invention, a high contact force can be obtained between the insulating material film and the cooling roller, both before and after the deposition of metal film. Thus, the thermal deformation of material film can be prevented. The film-running speed and the productivity can be improved.

### [Brief Description of the Drawings]

Fig. 1 is a schematic view of a vacuum evaporation deposition apparatus of the winding type 10 according to one embodiment of this invention;
Fig. 2 shows a film-forming surface of the material film. Fig. 2A shows the situation of formed oil pattern 25 and Fig. 2B shows the situation after the deposition of the metal film 26;
Fig. 3 is a cross-sectional schematic view for explaining an electron beam radiating step to the material film 12;
Fig. 4 is a cross-sectional schematic view for explaining attracting force between said material film 12 and said can roller 14 after the deposition of metal film;
Fig. 5 is a schematic view of a prior art vacuum evaporation deposition apparatus of the winding type.

### [Explanations of Letters or Numerals]

- 10: vacuum evaporation deposition apparatus of the winding type
- 11: vacuum chamber
- 12: material film
- 13: unwinding roller
- 14: can roller (cooling roller)
- 15: take-up roller
- 16: evaporating source
- 18: auxiliary roller
- 20: pattern forming unit (mask-forming means)
- 21: electron beam irradiator (charged-particle irradiating means)
- 22: DC bias electric source (voltage applying means)
- 23: electricity removal means for removing electricity
- 25: oil pattern
- 26: metal film
- 27: sensor (detecting means)
- 28: controller (controlling means)

### [Best Embodiment of Invention]

Next, an embodiment of this invention will be described with reference to the drawings.

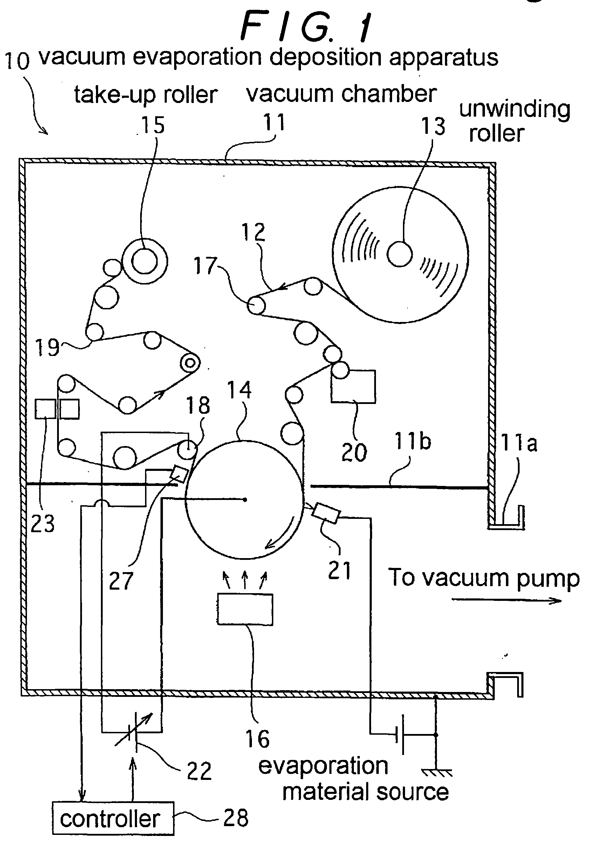

Fig. 1 is a schematic view of a vacuum evaporation deposition apparatus of the winding type according to the embodiment of this invention. The vacuum evaporation deposition apparatus of the winding type 10 according to the embodiment is provided with a vacuum chamber 11, an unwinding roller 13 for a material film 12, a cooling can roller 14, a take-up roller 15 and an evaporation deposition source 16 of material to be deposited.

The vacuum chamber 11 is connected through a conduit portion 11a to a vacuum exhaust system including a vacuum pump. The interior of the vacuum chamber 11 is exhausted to a predetermined pressure and it is partitioned into two rooms by a partition wall 11b. The unwinding roller 13 and take-up roller 15 are arranged in the one of the rooms and the evaporation source 16 is arranged in another of the rooms.

The material film 12 is a long insulating plastic film cut into a predetermined width. OPP (orienting polyplopylen) film is used in this embodiment. PET (polyethylene terephthalate) film, PPS (polyphenylene sulfide) film and a paper sheet can be used.

The material film 12 is dispensed from the unwinding roller 13 and wound on the take-up roller 13 through plural guide rollers 17, a can roller 14, and an auxiliary roller 18 and plural guide rollers 19. The above unwinding roller 13 and the take-up roller 15 correspond to a unwinding means and a take-up means of this invention. Although not shown, rotation drives are arranged at the unwinding roller 13 and the take-up roller 15, respectively.

The can roller 14 is cylindrical in shape and it is made of metal such as stainless. A cooling mechanism such as circulating system of cooling water, a rotational drive mechanism for driving can roller 14 and etc, are included in the can roller 14. The material film 12 is wound on the can roller 14, at a predetermined angle range and evaporating material from the evaporating source 16 is deposited on outside surface of the material film 12, at the same time, the material film 12 is cooled by the can roller 14.

The evaporating source 16 contains material to be deposited. It is heated by a resistance heater, inductive heater, electron beam or the prior art heating method. A depositing material is heated in the evaporation deposition source 16, which is arranged under the can roller 14. The evaporation material from the source 16 is deposited onto the material film 12 wrapped on the can roller 14.

Metal elements such as Al, Co, Cu, Ni, Ti and further Al-Zn, Cu-Zn and Fe-Co made of two or more kinds of metal or alloy may be used. Plural evaporation sources may be arranged instead of one evaporation source.

The vacuum evaporation deposition apparatus 10 of the winding type according to this embodiment is provided further with a pattern forming unit 20, an electron beam irradiator 21, a DC bias source 22 and an electricity removing unit 23.

The pattern forming unit 20 forms a region to be deposited with metal film on the material film 12. It corresponds to "mask forming means" of this invention arranged between the unwinding roller 13 and the can roller 14.

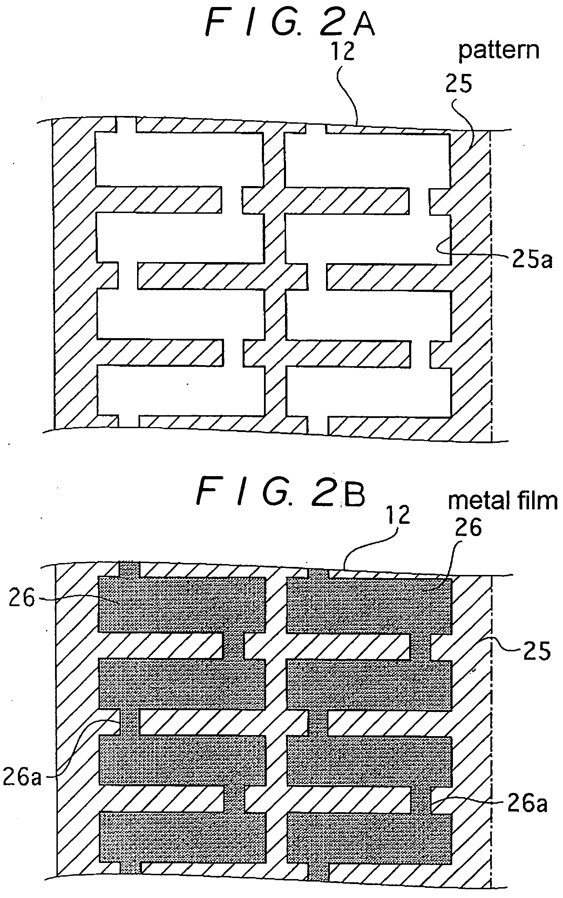

Fig. 2 shows the film-forming surface of the material film 12. The pattern forming unit 20 forms an oil pattern 25 as shown by hatching in Fig.2A. Plural rows of oil are formed as coated on the material film 12 along the running direction or lengthwise direction. Rectangular metal patterns 25 are formed by the deposition of the material from the evaporation deposition source 16 in opening portions 25a. They are connected through connecting portions 26a at a predetermined pitch. Thus, the plural rows of metal film 26 are formed on the material film 12 as shown in Fig.2B. Of course, the pattern of the deposited metal film is not limited to the shape as shown on Fig.2.

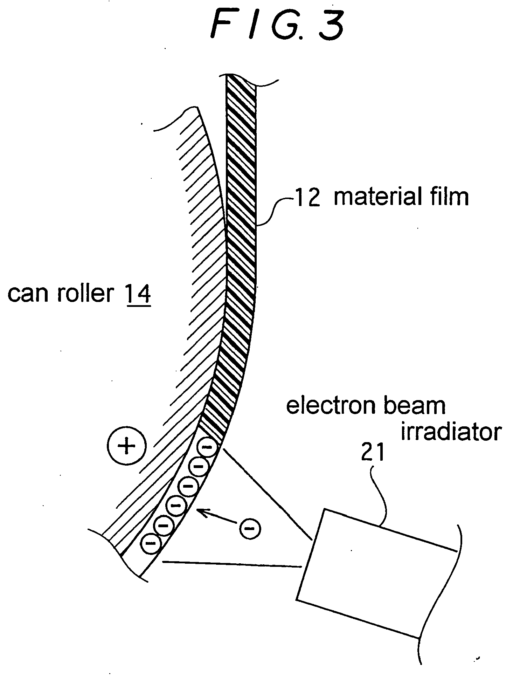

The electron beam irradiator 21 corresponds to "charged-particles radiating means" of this invention. Electron beams as the charged-particles are irradiated onto the material film 12, and so it is negatively charged. Fig.3 is a cross-sectional schematic view for explaining the radiating step of the electron beam onto the material film 12. In this embodiment, the electron beam irradiator 21 is arranged facing to the peripheral surface of the can roller 14. The electron beams are irradiated onto the surface to be deposited, of the material film 12. Since the electron beams are irradiated onto the material film 12 in contact with the can roller 14, the material film 12 being cooled, receives electron beam.

In this embodiment, the electron beam irradiator 21 scans radiating electron beam on the material film 12 in the width direction of the material film 12. Thus, the material film 12 is prevented from damages due to local irradiation of electron beam onto the material film 12. Thus, the material film 12 can be charged uniformly and effectively.

A predetermined DC voltage is applied between the can roller 14 and the auxiliary roller 18 by the DC bias power source 22, which correspond to "voltage applying means" of this Invention. In the embodiment, the can roller 14 is connected to a positive electrode of the DC power source 22 and the auxiliary roller 18 is connected to a negative electrode of the DC power source 22. Thus, the material film 12 negatively charged by the radiation of the electron beam is electrostaticly attracted to the surface of the can roller 14 as shown in Fig.3. Thus, the material film 12 is contacted closely with the can roller 14.

The auxiliary roller 18 is made of metal and the peripheral surface of the auxiliary roller 18 contacts rolling on the deposition surface of the material film 12.

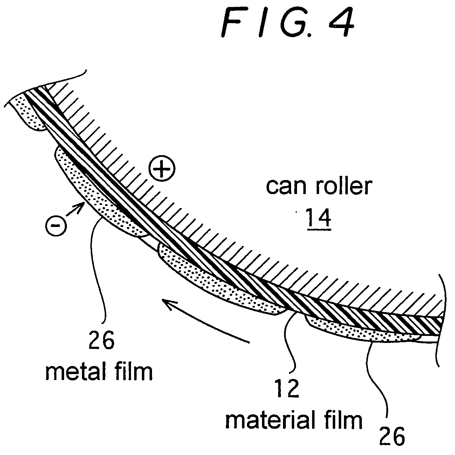

Fig.4 is a cross-sectional schematic view for explaining the attraction between the material film 12 after deposition and the can roller 14. Pattern like metal film 26 is formed on the material film 12 by the deposition. The metal film 26 is continuous in the longitudinal direction as shown in Fig.2B. The auxiliary roller 18 is connected to the negative electrode of the DC voltage source 22. It guides the material film 12 on the metal film side. Negative potential is applied to the metal film in contact with the peripheral surface of the auxiliary roller 18 on the deposited surface of the metal film 26 as shown in Fig.2B. As the result, in the material film 12 interposed between the metal film 26 and the can roller 14, polarization occurs. And so electro-static attractive force occurs between the material film 12 and the can roller 14. And so close contact force is obtained between the can roller 14 and the material film 12.

Particularly in this embodiment, the DC bias power source 22 is variable. The potential applied onto the metal film 26 of the material film 12 is monitored to stabilize the voltage applied to the metal film 26. Thus, it can be avoided that the contact force of the material film 12 to the can roller 14 is lowered due to variation of the applied voltage to the metal film 26, and short-circuit is made between the metal film 26 and the can roller 14 to cause splash and damage.

In this embodiment, the vacuum evaporation deposition apparatus 10 of the winding type is provided a sensor 27 for detecting the surface potential of the metal film 26 on the material film 12 at the upper stream side of the auxiliary roller 18 with respect to the film running direction, and a controller 28. It receives the output of the detecting sensor 27 and controls the DC bias voltage source 22 so that the potential of the metal film 26 is put within a predetermined range.

The predetermined range is between the lowest permissible voltage, so high as to obtain the suitable close contact force of the material film 12 to the can roller 14 and the highest permissible voltage to bring splash damages of the depositing metal. It can be suitably selected in accordance with kind of material film 12, thickness thereof and film running speed, etc.

A surface potential meter of the type for measuring film surface potential is used as the sensor 27. An electrode in the measuring probe is vibrated and displacement current in accordance with the film surface potential is induced in the probe electrode. This invention is not limited to the construction for controlling the applying voltage in accordance with a film surface potential. For example, the applying voltage may be so controlled by measuring temperature of the material film 12.

The electricity-removing unit 23 corresponds to electricity-removing means of this invention. It is arranged between the auxiliary roller 18 and the take-up roller 15. It has function to remove electricity due to electron beam from the electron beam irradiator 21. In one example of the electricity-removing means, the running material film 12 is plasma-bombarded to remove the electricity of the material film 12.

Next, the evaporation deposition method of the winding type will be described together with the operations of the evaporation deposition apparatus of the winding type 10 according to the embodiment of this invention.

The material film 12 is continuously dispensed from the unwinding roller 13. It is passing through the oil-pattern forming process by the oil-pattern forming unit 25, the electron beam radiating process, the evaporation deposition process and the electricity-removing process and is continuously received by the take-up roller 15.

In the mask forming process, the oil pattern 25 is coated on the material film 12, for example, in the shape as shown in Fig.2A by the pattern-forming unit 20. Instead, such a mask forming method can be employed that a transcription roller rolls on the material film 12 to transcribe a necessary pattern thereon.

The material film 12 with the oil pattern formed is wrapped onto the can roller 14. Near the position of the contact start with the can roller 14, the material film 12 is irradiated with the electron beam from the electron beam irradiator 21, and so it is negatively charged. Since the material film 12 is irradiated with the electron beam at the position of the contact with can roller 14, the material film 12 can be effectively cooled by the can roller 14. Further, since the electron beam is irradiated scanning, on the material film in the width direction, the thermal deformation of the material film 12 can be avoided, and further it can be uniformly and effectively charged

The material film 12 negatively charged by the irradiation of the electron beam is electro-statically attracted and contacted closely with the can roller 14 biased positively by the DC bias voltage source 22, as shown in Fig.3. Material to be deposited, evaporated from the evaporation material source 16 is piled on the surface, of the material film 12. Thus, the metal film 26 as stripes as shown in Fig.2B is formed on the material film 12. Plural rows of the stripes are connected through the connecting portions 26, extended in the lengthwise direction of the material film 12.

The negative potential of the DC bias voltage source 22 is applied through the auxiliary roller 18 to the metal film 26 formed on the material film 12. After the deposition of the metal film 26, the one surface of the material film 12 wrapped on the can roller 14 at the side of the metal film 26 is positively polarized, and the other surface of the material film 12 at the side of the can roller 14 is negatively polarized. Thus, electro-static attractive force occurs between the material film 12 and the can roller 14. As the result, the material film 12 is closely contacted with the can roller 14.

As above described, in this embodiment, the material film 12 is charged with the irradiation of the electron beam before the deposition of the metal film 26, to be closely contacted with the can roller 14. After the deposition, of the metal film 26, the material film 12 is closely contacted with the can roller 14 with the bias voltage applied between the metal film 26 and the can roller 14. Although a part of charges (electrons) on the material film 12 charged before the deposition of the metal film 26 is discharged and dissipated into the metal film during the deposition of the metal on the material film 12, all or a part of the dissipated charges is compensated with the application (supply of the electrons) of the negative potential to the metal film 26 from the auxiliary roller 18.

Accordingly, according to the embodiment of this invention, the decrease of the contact force between the material film 12 and the can roller 14 is suppressed also after the evaporating deposition step, and so the stable cooling operation of the material film 12 can be secured both before the evaporating deposition and after evaporating deposition. Thus, the thermal deformation of the material film 12 can be avoided during the evaporation deposition of the metal film. The running speed of the material film 12 and the metal film forming speed can be raised. Thus, the productivity can be improved. This embodiment is particularly useful for the material film 12 made of material being hard to be charged, with the metal film deposited, such as OPP film. When the metal film 26 is pattern-likely formed on the material film 12 as in this embodiment, the temperature is locally raised, and the amount of the charges sometimes varies. The discharged metal film-forming portion is compensated with the bias voltage and so the contact force between the material film and the can roller can be strengthened. That is advantages, because the material film 12 is uniformly cooled.

Further in this embodiment, since the voltage applied between the can roller 14 and the auxiliary roller 18 is controlled on the basis of the surface potential of the metal film 26 on the material film 12, the close contact between the material film 12 and the can roller 14 can be stably maintained and the thermal damage such as splash can be avoided.

The metal film 26 is deposited on the insulating material film 12 in the above described manner. It is subject to the electricity removal by the electricity removal unit 23 and is then taken up onto the winding roll 15. Thus, the stable winding operation of the insulating material film 12 can be secured and the insulating material film can be prevented from shrinking or wrinkling due to the electricity.

Next, the example will be described.

The maximum driving speed permissible was measured at which the metal film can be formed on the insulating material film 12 without thermal deformation such as shrink or wrinkle. In the case of only the bias voltage, in the case of only the electron beam radiation, and in the case of the bias voltage plus electron beam radiation , respectively.

Insulating material film 12 : OPP film 600mm width, 4 µm thickness. Metal AL film: film thickness of sheet resistance 2 Ω/□.

Electron beam irradiator : Electron beam gun of the scanning type 4KV X 100~ 200mA, scanning frequency 1000Hz. And DC bias voltage source 22 : 100~120V.

The results of the experiment as follows:
The case of only bias voltage: 300m/min.
The case of only electron beam radiation: 250 m/min.
The case of the bias voltage plus electron beam radiation: 500m/min.

Thus, it has been proved according to this invention that the close contact of the insulating material film 12 with the can roller14, can be securely obtained and the driving speed can be raised with the additional effect of the bias voltage application and the electron beam radiation.

While the preferred embodiments of the Invention have been described, without limited to this, variations thereto will occur to those skilled in the art within the scope of the present inventive concepts that are delineated by the following claims.

For example, in the above embodiment, the metal film 26 is deposited on the insulating material film 12 in the shape of stripes connected through the connecting portions 26a as shown in Fig.2B. The pattern is not limited to the shown type. For example, linear patterns along the lengthwise direction of the insulating material film can be employed in the scope of this invention or a metal film may be formed as single layer and uniform patternless shape, on the insulating material film 12.

Further, in the above embodiment, the electron beams are irradiated on the insulating material film 12 to negatively charge. Instead of the electron beam, ions may be irradiated on the insulating material film 12 to positively charge. In this case, polarities applied between the can roller 14 and the auxiliary roller 18 are inverted from the above embodiment. Thus, the can roller 14 is connected to the negative electrode and the auxiliary roller 18 is connected to the positive electrode.

## Claims

1. A vacuum evaporation deposition method of the winding type in which under the atmosphere of reduced pressure, an insulating material film (12) is continuously fed out, cooled in close contact with a cooling roller (14) and metal is evaporated onto the insulating material film to deposit a metal film thereon, **characterized in that**
before the deposition of the metal film, the insulating material film is closely contacted with the cooling roller by charging the insulating material film, and
after the deposition of the metal film, the insulating material film is closely contacted with the cooling roller by applying a DC voltage between an auxiliary roller (18) for guiding the insulating material film and the cooling roller, the auxiliary roller is in contact with the metal film on the insulating material film and is arranged between the cooling roller and a winding roller (15) for taking up the insulating material film, and
electricity of the insulating material film are removed by an electricity removing unit (23) arranged between the auxiliary roller and the winding roller, the electricity removing unit removes the electricity of the insulating material film passing through the electricity removing unit.

2. A vacuum evaporation deposition method of the winding type according to claim 1, in which in the step of charging the insulating material film, charged particles are irradiated onto the running insulating material film, being scanned in the width direction of the insulating material film.

3. A vacuum evaporation deposition method of the winding type according to claim 2, in which the charged particles are irradiated, at the time when the insulating material film has contacted with the cooling roller.

4. A vacuum evaporation deposition method of the winding type according to claim 1, in which the step of applying the DC voltage between the metal film and the cooling roller includes a step of measuring a surface potential of the metal film and another step of so controlling the applying voltage as to put the surface potential within a predetermined range.

5. A vacuum evaporation deposition method of the winding type according to claim 1, in which a mask pattern for defining a deposition region of the metal film is formed on the surface to be deposited, of the material film before the step of charging the insulating material film.

6. A vacuum evaporation deposition apparatus of the winding type in which there are provided in a vacuum chamber (11), an unwinding roller (13) for continuously feeding an insulating material film (12), a winding roller (15) for taking up the insulating material film, a cooling roller (14) for cooling the insulating material film in contact, arranged between the unwinding roller, and the winding roller, and an evaporation source (16) for depositing a metal film on the insulating material film, arranged in face to the cooling roller, **characterized in that** the apparatus comprises,
charged-particles irradiating means (21) for irradiating charged particles onto the insulating material film, arranged between the unwinding roller and the evaporation source,
an auxiliary roller (18) for guiding the insulating material film in contact with the deposited metal film, arranged between the winding roller and the cooling roller,
voltage-applying means (22) for applying a DC voltage between the auxiliary roller and the cooling roller, and
an electricity removing unit (23), arranged between the auxiliary roller and the winding roller, for removing electricity of the insulating material film passing through the electricity removing unit by plasma-bombarding.

7. A vacuum evaporation deposition apparatus of the winding type according to claim 6, in which there is provided detecting means (27) for detecting a surface potential of the metal film deposited on the insulating material film, arranged between the cooling roller and the auxiliary roller and controlling means (28) for controlling the applying voltage of the voltage supplying means on the basis of the detected output of the detecting means.

8. A vacuum evaporation deposition apparatus of the winding type according to claim 6, in which the charged-particles irradiating means is arranged in face to the peripheral surface on the cooling roller.

9. A vacuum evaporation deposition apparatus of the winding type according to claim 6, in which mask-pattern forming means (20) is arranged between the unwinding roller and the charged-particles irradiating means, for defining a mask pattern of the deposition regions of the metal film on the insulating material film.

## Patentansprüche

1. Vakuumaufdampfungs-Ablagerungsverfahren vom Wickeltyp, bei dem in einer Atmosphäre mit verringertem Druck eine Schicht (12) aus isolierendem Material fortlaufend ausgegeben wird, in engem Kontakt mit einer Kühlwalze (14) gekühlt wird und Metall auf die Schicht aus isolierendem Material aufgedampft wird, um eine Metallschicht darauf abzulagern, **dadurch gekennzeichnet, dass**
vor dem Ablagern der Metallschicht die Schicht aus isolierendem Material durch Aufladen der Schicht aus isolierendem Material mit der Kühlwalze in engen Kontakt gebracht wird, und
nach dem Ablagern der Metallschicht die Schicht aus isolierendem Material durch Anlegen einer Gleichspannung zwischen einer Hilfswalze (18) zum Führen der Schicht aus isolierendem Material und der Kühlwalze mit der Kühlwalze in engen Kontakt gebracht wird, wobei die Hilfswalze mit der Metallschicht auf der Schicht aus isolierendem Material in Kontakt ist und zwischen der Kühlwalze und einer Wickelwalze (15) zum Aufnehmen der Schicht aus isolierendem Material angeordnet ist, und
elektrische Ladungen der Schicht aus isolierendem Material durch eine Einheit (23) zum Entfernen von elektrischen Ladungen, die zwischen der Hilfswalze und der Wickelwalze angeordnet ist, entfernt werden, wobei die Einheit zum Entfernen der elektrischen Ladungen die elektrischen Ladungen der Schicht aus isolierendem Material, die durch die Einheit zum Entfernen der elektrischen Ladungen läuft, entfernt.

2. Vakuumaufdampfungs-Ablagerungsverfahren vom Wickeltyp nach Anspruch 1, bei dem im Schritt des Aufladens der Schicht aus isolierendem Material geladene Partikel auf die fortlaufende Schicht aus isolierendem Material, die in ihrer Breitenrichtung abgetastet wird, gestrahlt werden.

3. Vakuumaufdampfungs-Ablagerungsverfahren vom Wickeltyp nach Anspruch 2, bei dem geladene Partikel zu dem Zeitpunkt aufgestrahlt werden, zu dem die Schicht aus isolierendem Material mit der Kühlwalze in Kontakt ist.

4. Vakuumaufdampfungs-Ablagerungsverfahren vom Wickeltyp nach Anspruch 1, bei dem der Schritt des Anlegens der Gleichspannung zwischen der Metallschicht und der Kühlwalze einen Schritt des Messens eines Oberflächenpotentials der Metallschicht und einen weiteren Schritt der Steuerung des Anlegens einer Spannung, derart, dass das Oberflächenpotential innerhalb eines vorher festgelegten Bereichs eingestellt wird, umfasst.

5. Vakuumaufdampfungs-Ablagerungsverfahren vom Wickeltyp nach Anspruch 1, bei dem vor dem Schritt des Aufladens der Schicht aus isolierendem Material eine Maskenstruktur zum Definieren eines Ablagerungsbereichs der Metallschicht auf der Oberfläche, auf der abgelagert werden soll, aus der Materialschicht ausgebildet wird.

6. Vakuumaufdampfungs-Ablagerungsvorrichtung vom Wickeltyp, bei der eine Vakuumkammer (11), eine Abwickelwalze (13) zur fortgesetzten Zufuhr einer Schicht (12) aus isolierendem Material, eine Wickelwalze (15) zum Aufnehmen der Schicht aus isolierendem Material, eine Kühlwalze (14) zum Kühlen der in Kontakt befindlichen Schicht aus isolierendem Material, die zwischen der Abwickelwalze und der Wickelwalze angeordnet ist, und eine Aufdampfungsquelle (16) zum Ablagern einer Metallschicht auf der Schicht aus isolierendem Material, die gegenüber der Kühlwalze angeordnet ist, enthalten sind, **dadurch gekennzeichnet, dass** die Vorrichtung Folgendes umfasst:
Mittel (21) zum Bestrahlen mit geladenen Partikeln, um auf die Schicht aus isolierendem Material geladene Partikel zu strahlen, wobei die Mittel zwischen der Abwickelwalze und der Aufdampfungsquelle angeordnet sind,
eine Hilfswalze (18) zum Führen der Schicht aus isolierendem Material in Kontakt mit der abgelagerten Metallschicht, wobei die Hilfswalze zwischen der Wickelwalze und der Kühlwalze angeordnet ist,
Mittel (22) zum Anlegen einer Spannung, um eine Gleichspannung zwischen der Hilfswalze und der Kühlwalze anzulegen, und
eine Einheit (23) zum Entfernen von elektrischen Ladungen, die zwischen der Hilfswalze und der Wickelwalze angeordnet ist, um elektrische Ladungen von der Schicht aus isolierendem Material, die durch die Einheit zum Entfernen von elektrischen Ladungen läuft, durch Plasma-Bombardement zu entfernen.

7. Vakuumaufdampfungs-Ablagerungsvorrichtung vom Wickeltyp nach Anspruch 6, bei der Detektionsmittel (27) zum Detektieren eines Oberflächenpotentials der Metallschicht, die auf der Schicht aus isolierendem Material abgelagert ist, die zwischen der Kühlwalze und der Hilfswalze angeordnet sind, und Steuermittel (28) zum Steuern des Anlegens einer Spannung der Spannungsversorgungsmittel anhand des detektierten Ausgangssignals der Detektionsmittel enthalten sind.

8. Vakuumaufdampfungs-Ablagerungsvorrichtung vom Wickeltyp nach Anspruch 6, bei der die Mittel zum Bestrahlen mit geladenen Partikeln gegenüber der Umfangsfläche der Kühlwalze angeordnet sind.

9. Vakuumaufdampfungs-Ablagerungsvorrichtung vom Wickeltyp nach Anspruch 6, bei der die Mittel (20) zum Ausbilden einer Maskenstruktur zwischen der Abwickelwalze und den Mitteln zum Bestrahlen mit geladenen Partikeln angeordnet sind, um eine Maskenstruktur der Ablagerungsbereiche der Metallschicht auf der Schicht aus isolierendem Material zu definieren.

## Revendications

1. Procédé de dépôt par évaporation sous vide du type enroulement dans lequel, sous une atmosphère de pression réduite, un film de matériau isolant (12) est déroulé en continu, refroidi en contact étroit avec un rouleau refroidisseur (14) et un métal est évaporé sur le film de matériau isolant pour y déposer un film métallique, **caractérisé en ce que**
avant le dépôt du film métallique, le film de matériau isolant est mis en contact étroit avec le rouleau refroidisseur en chargeant le film de matériau isolant, et
après le dépôt du film métallique, le film de matériau isolant est mis en contact étroit avec le rouleau refroidisseur en appliquant une tension CC entre un rouleau auxiliaire (18) servant à guider le film de matériau isolant et le rouleau refroidisseur, le rouleau auxiliaire est en contact avec le film métallique sur le film de matériau isolant et est disposé entre le rouleau refroidisseur et un rouleau enrouleur (15) servant à enrouler le film de matériau isolant, et
l'électricité du film de matériau isolant est retirée par une unité de retrait d'électricité (23) disposée entre le rouleau auxiliaire et le rouleau enrouleur, l'unité de retrait d'électricité retire l'électricité du film de matériau isolant passant à travers l'unité de retrait d'électricité.

2. Procédé de dépôt par évaporation sous vide du type enroulement selon la revendication 1 dans lequel, à l'étape de charge du film de matériau isolant, des particules chargées sont irradiées sur le film de matériau isolant en mouvement, étant balayées dans la direction de la largeur du film de matériau isolant.

3. Procédé de dépôt par évaporation sous vide du type enroulement selon la revendication 2, dans lequel les particules chargées sont irradiées au moment où le film de matériau isolant a touché le rouleau refroidisseur.

4. Procédé de dépôt par évaporation sous vide du type enroulement selon la revendication 1, dans lequel l'étape d'application de la tension CC entre le film métallique et le rouleau refroidisseur comporte une étape consistant à mesurer un potentiel de surface du film métallique et une autre étape consistant à contrôler ainsi la tension appliquée de manière à amener le potentiel de surface dans une gamme prédéterminée.

5. Procédé de dépôt par évaporation sous vide du type enroulement selon la revendication 1, dans lequel un motif de masque servant à définir une région de dépôt du film métallique est formé sur la surface du film de matériau à recouvrir avant l'étape de charge du film de matériau isolant.

6. Appareil de dépôt par évaporation sous vide du type enroulement dans lequel il est prévu une chambre à vide (11), un rouleau dérouleur (13) servant à fournir en continu un film de matériau isolant (12), un rouleau enrouleur (15) servant à enrouler le film de matériau isolant, un rouleau refroidisseur (14) servant à refroidir le film de matériau isolant en contact, disposé entre le rouleau dérouleur et le rouleau enrouleur, et une source d'évaporation (16) servant à déposer un film métallique sur le film de matériau isolant, disposée en face du rouleau refroidisseur, **caractérisé en ce que** l'appareil comprend
un moyen d'irradiation de particules chargées (21) servant à irradier des particules chargées sur le film de matériau isolant, disposé entre le rouleau dérouleur et la source d'évaporation,
un rouleau auxiliaire (18) servant à guider le film de matériau isolant en contact avec le film métallique déposé, disposé entre le rouleau enrouleur et le rouleau refroidisseur,
un moyen d'application de tension (22) servant à appliquer une tension CC entre le rouleau auxiliaire et le rouleau refroidisseur, et
une unité de retrait d'électricité (23), disposée entre le rouleau auxiliaire et le rouleau enrouleur, servant à retirer l'électricité du film de matériau isolant passant à travers l'unité de retrait d'électricité par bombardement plasma.

7. Appareil de dépôt par évaporation sous vide du type enroulement selon la revendication 6, dans lequel il est prévu un moyen de détection (27) servant à détecter un potentiel de surface du film métallique déposé sur le film de matériau isolant, disposé entre le rouleau refroidisseur et le rouleau auxiliaire, et un moyen de contrôle (28) servant à contrôler la tension appliquée du moyen d'application de tension en fonction de la sortie détectée du moyen de détection.

8. Appareil de dépôt par évaporation sous vide du type enroulement selon la revendication 6, dans lequel le moyen d'irradiation de particules chargées est disposé en face de la surface périphérique sur le rouleau refroidisseur.

9. Appareil de dépôt par évaporation sous vide du type enroulement selon la revendication 6, dans lequel un moyen de formation de motif de masque (20) est disposé entre le rouleau dérouleur et le moyen d'irradiation de particules chargées, pour définir un motif de masque des régions de dépôt du film métallique sur le film de matériau isolant.
